# EUROPEAN PATENT SPECIFICATION

(11) **EP 4 513 390 B1**
(45) Date of publication and mention of the grant of the patent: **26.08.2026**
(21) Application number: 24192054.5
(22) Date of filing: 31.07.2024
(51) Int. Cl.: G06N 10/70, H03M 13/45, H03M 13/11

(54) **METHOD AND SYSTEM OF QUANTUM ERROR CORRECTION**
VERFAHREN UND SYSTEM ZUR QUANTENFEHLERKORREKTUR
PROCÉDÉ ET SYSTÈME DE CORRECTION D'ERREUR QUANTIQUE

(30) Priority: 03.08.2023 US 202363517473 P
(43) Date of publication of application: 26.02.2025
(73) Proprietor: Xanadu Quantum Technologies Inc., Toronto, ON M5G 2C8 (CA)
(72) Inventor: Nadkarni, Priya Jai Bharath, Toronto (CA); Dauphinais, Guillaume, Toronto (CA)
(74) Representative: Lehmann Novo, Maria Isabel

(56) References cited:
- C.-F. KUNG ET AL: "On belief propagation decoding of quantum codes with quaternary reliability statistics", ARXIV.ORG, CORNELL UNIVERSITY LIBRARY, 201 OLIN LIBRARY CORNELL UNIVERSITY ITHACA, NY 14853, 15 July 2023 (2023-07-15), XP091564667, DOI: 10.48550/arXiv.2305.03321
- Y. URMAN ET AL: "Improving belief propagation list decoding of polar codes by post-processing", PROCEEDINGS OF THE 2022 IEEE INTERNATIONAL SYMPOSIUM ON INFORMATION THEORY (ISIT'22), 26 June 2022 (2022-06-26), pages 2571 - 2576, XP034160504, DOI: 10.1109/ISIT50566.2022.9834896
- P. PANTELEEV, G. KALACHEV: "Degenerate quantum LDPC codes with good finite length performance", ARXIV.ORG, CORNELL UNIVERSITY LIBRARY, 201 OLIN LIBRARY CORNELL UNIVERSITY ITHACA, NY 14853, 12 November 2021 (2021-11-12), XP091084697, DOI: 10.48550/arXiv.1904.02703
- J. ROFFE ET AL: "Decoding across the quantum LDPC code landscape", ARXIV.ORG, CORNELL UNIVERSITY LIBRARY, 201 OLIN LIBRARY CORNELL UNIVERSITY ITHACA, NY 14853, 29 December 2020 (2020-12-29), XP081848043, DOI: 10.48550/arXiv.2005.07016

## Description

### TECHNICAL FIELD

The present application relates to quantum error correction, and in particular to a method and system for determining and correcting syndrome measurements produced by a quantum computer.

### BACKGROUND OF THE INVENTION

Error correction is a necessary component of any fault-tolerant quantum computing (FTQC) architecture. Noise along a quantum circuit can induce errors in the qubits, which must be corrected for. Quantum error correction remains an active field of research, with various error correction codes and decoding schemes being studied.

There are many decoding algorithms known in the art. Examples of decoding algorithms include minimum-weight perfect matching (MWPM), union-find (UF), belief propagation (BP), and ordered statistics decoding (OSD) among others. Each decoding algorithm has its respective advantages and disadvantages. For example, BP can be run relatively quickly and with fewer computational resources, but the algorithm doesn't always converge. In contrast, OSD always provides a recovery operator, but is more computationally expensive than BP.

Accordingly, it is desirable to provide an improved method and system of a quantum error correction decoder that at least partially overcomes one or more of the shortcomings of the prior art. On 15 July 2023, Kung et al. (On belief propagation decoding of quantum codes with quaternary reliability statistics; arXiv:2305.03321v2; DOI:10.48550/arXiv.2305.03321) disclosed using quaternary reliability statistics for ordered statistics decoding (OSD) of quantum codes and the hard-decision history output by belief propagation (BP) decoding, to perform reliability sorting for OSD and improve the performance of BP decoding when it fails to correct the error syndrome.

### SUMMARY OF THE INVENTION

The invention is defined in independent claim 1.

Preferred embodiments are defined in the dependent claims.

In some aspects of the present disclosure, a quantum error correction decoding method and apparatus is provided. In some implementations, the error-correcting decoding method is used in quantum computing systems, such as photonic quantum computing systems, to implement fault-tolerant quantum computation.

In some embodiments, the decoding methods and apparatus described herein may be used in conjunction with topological error-correcting codes, such as surface codes, and other quantum low density parity check (LDPC) codes.

In some embodiments, one or more of the quantum error-correction decoding methods described herein can be applied to multi-mode entangled photonic states in higher dimensions (i.e., three (3) dimensions or higher of temporal, spatial, or a hybrid of spatial-temporal dimensions) generated by a two-dimensional photonic integrated circuit (PIC).

In some embodiments, one or more of the methods described herein are used to implement an improved OSD method with reduced computational overhead such that OSD may be used in conjunction with other decoding algorithms, such as BP, to achieve a decoding scheme with higher computational efficiency.

In some embodiments, the quantum error-correction decoding methods described herein incorporate adjustable parameters that permit flexibility between computational efficiency and accuracy.

In some embodiments, the quantum error-correction decoding methods described herein decrease the overall decoding time by exploiting the sparse nature of the matrices involved.

According to a first example aspect, there is provided an improved method of OSD where the method comprises: generating, by a decoder, a matrix having a rank of r based on stabilizer data and a plurality of error probability weights, the matrix including a first sub-matrix defined as the r linearly independent columns of the matrix; initializing a transformation matrix of the same size as the first sub-matrix; updating the transformation matrix with one or more linear transformations generated based on a transformation vector determined as a dot product of the transformation matrix and a non-zero column of the matrix; and determining an estimated error based on the updated transformation matrix.

According to a second example aspect, not covered by the claims, there is provided a non-transitory, computer-readable medium containing executable instructions that, when executed, cause a processor to: generate, by a decoder, a matrix having a rank of r based on stabilizer data and a plurality of error probability weights, the matrix including a first sub-matrix defined as the r linearly independent columns of the matrix; initialize a transformation matrix of the same size as the first sub-matrix; update the transformation matrix with one or more linear transformations generated based on a transformation vector determined as a dot product of the transformation matrix and a non-zero column of the matrix; and determine an estimated error based on the updated transformation matrix.

In any of the above aspects relating to the first example aspect, the matrix may be an *m* × *n* sparse matrix, and the first sub-matrix may be a full-rank matrix of rank *r,* where *r* = *m,* and *m* is the number of rows of the first sub-matrix.

In any of the above aspects relating to the first example aspect, the updating of the transformation matrix may further comprise: iterating through at least *r* leftmost linearly independent columns of the matrix, wherein each iteration performs: identifying, in the matrix, a column number *j* as the column with at least one non-zero element with a row index of at least *i,* and identifying one or more row indices for each of the non-zero elements of the transformation vector other than the *i*-th element of the transformation vector; and applying the *i*-th row of the transformation matrix to each row of the transformation matrix identified by a row index of the one or more row indices.

Any of the above aspects, relating to the first example aspect, may further comprise reordering the columns of the matrix and the syndrome data based on a corresponding error probability weight from the plurality of error probability weights.

In any of the above aspects relating to the first example aspect, the columns of the matrix may be reordered from least to greatest error probability weight.

In any of the above aspects relating to the first example aspect, each error probability weight of the plurality of error probability weights may be determined by ${w}_{e} = \frac{1 - p}{p}$, where *p* is a probability of error.

In any of the above aspects relating to the first example aspect, the matrix may further include a second sub-matrix defined as the remaining *(n* - *r*) columns of the matrix, where *n* is the total number of columns of the matrix, and the method may further comprise: receiving an ordered statistics decoding (OSD) order parameter; iterating through a plurality of binary vectors, where each binary vector of the plurality of binary vectors comprises *(n* - *r*) bits where the number of non-zero bits in each binary vector is defined by the OSD order parameter, wherein each iteration comprises determining a corrective error based on the second sub-matrix, the updated transformation matrix, and a binary vector of the plurality of binary vectors, updating the estimated error with the corrective error to derive an updated estimated error, and determining a probability of the updated estimated error; and identifying a binary vector of the plurality of binary vectors that resulted in the updated estimated error having the highest error probability.

In any of the above aspects relating to the first example aspect, the plurality of binary vectors may include all permutations of (*n* - *r*) bits having a number of non-zero bits specified by the OSD order parameter, and the binary vector having the highest error probability may be identified as a binary vector having the lowest error probability weight.

In any of the above aspects relating to the first example aspect, the estimated error may represent one of a bit-flip error and a phase-flip error.

In any of the above aspects relating to the first example aspect, the updated estimated error *ê_{S}* may be determined by *ê_{S}^{T}* = *ê_{S}*⁽⁰⁾*^{T} - H_{S}*⁻¹*H_{T}ê_{T}^{T},* where *ê_{S}*⁽⁰⁾ is the estimated error, *ê_{T}* is the corrective error, *H_{S}⁻¹* is the updated transformation matrix, *H_{T}* is the second sub-matrix, and *ê_{T}^{T}* is a binary vector of the plurality of binary vectors.

In any of the above aspects relating to the first example aspect, the updated estimated error *ê_{S}* may be a binary string of *n* bits, where the first *r* bits correspond to the estimated error, and the remaining (*n* - *r*) bits correspond to the corrective error.

In any of the above aspects relating to the first example aspect, the estimated error *ê_{S}*⁽⁰⁾ may be determined by ${\hat{e}}_{s}^{{\left(0\right)}^{T}} = {{H}_{s}}^{- 1} {s}^{T}$ *,* where *s^{T}* is a syndrome data.

In any of the above aspects relating to the first example aspect, the plurality of error probability weights may be a plurality of updated error probability weights generated by an alternate decoding method.

In any of the above aspects relating to the first example aspect, the alternate decoding method may be a belief propagation method.

In any of the above aspects relating to the first example aspect, the stabilizer data may be one of a check matrix or a Tanner graph.

In any of the above aspects, relating to the second example, to update the transformation matrix, the executable instructions may further cause the processor to: iterate through at least *r* leftmost linearly independent columns of the matrix, wherein each iteration performs identifying, in the matrix, a column number *j* as the column with at least one non-zero element with a row index of at least *i* and identifying one or more row indices for each of the non-zero elements of the transformation vector other than the *i*-th element of the transformation vector; and apply the *i-*th row of the transformation matrix to each row of the transformation matrix identified by a row index of the one or more row indices.

In any of the above aspects, relating to the second example aspects, the executable instructions may further cause the processor to reorder the columns of the matrix and syndrome data based on a corresponding error probability weight from the plurality of error probability weights.

In any of the above aspects, relating to the second example aspects, the matrix may further include a second sub-matrix defined as the remaining (*n* - *r*) columns of the matrix, where *n* is the total number of columns of the matrix, the executable instructions may further cause the processor to receive an ordered statistics decoding (OSD) order parameter; iterate through a plurality of binary vectors, where each binary vector of the plurality of binary vectors comprises (*n* - *r*) bits where the number of non-zero bits in each binary vector is defined by the OSD order parameter, wherein each iteration the executable instructions cause the processor to determine a corrective error based on the second sub-matrix, the updated transformation matrix, and a binary vector of the plurality of binary vectors, update the estimated error with the corrective error to derive an updated estimated error, and determine a probability of the updated estimated error; and identify a binary vector of the plurality of binary vectors that resulted in the updated estimated error having the highest error probability.

### BRIEF DESCRIPTION OF THE DRAWINGS

Reference will now be made, by way of example, to the accompanying figures which show example embodiments of the present application, and in which:
FIG. 1 illustrates a simplified system-level block diagram of an exemplary quantum computing system compatible with embodiments of the present disclosure;
FIG. 2 illustrates a graphical representation of an exemplary Tanner graph compatible with some embodiments of the present disclosure;
FIG. 3A illustrates an example showing operations of the standard Gaussian elimination method;
FIG. 3B illustrates operations of the Gaussian elimination method in accordance with the present disclosure using the same example as the one shown in FIG. 3A; and
FIG. 4A illustrates the improvement in computational time (in seconds) between the BP-OSD decoding method employing the standard OSD approach and the improved OSD method described herein as a function of code distance for two squeezing factors;
FIG. 4B illustrates the OSD portion of the computational time in the plots of FIG. 4A;
FIG. 5 illustrates a flowchart of a method in accordance with exemplary embodiments of the present disclosure.

Like reference numerals are used throughout the Figures to denote similar elements and features. While aspects of the invention will be described in conjunction with the illustrated embodiments, it will be understood that it is not intended to limit the invention to such embodiments.

### DETAILED DESCRIPTION OF THE INVENTION

In some embodiments, one or more of the methods described herein are used to implement an improved error correction method to ameliorate issues of large computational overhead and increased complexity that are typically associated with OSD by leveraging the sparse nature of the matrices involved and computing a reduced set of information such that the decoding algorithm may be implemented either independently or in conjunction with other algorithms, with lower computational overhead.

In some embodiments, the methods described herein are used to implement quantum error-correction methods that permit a greater degree of computational flexibility between efficiency and accuracy.

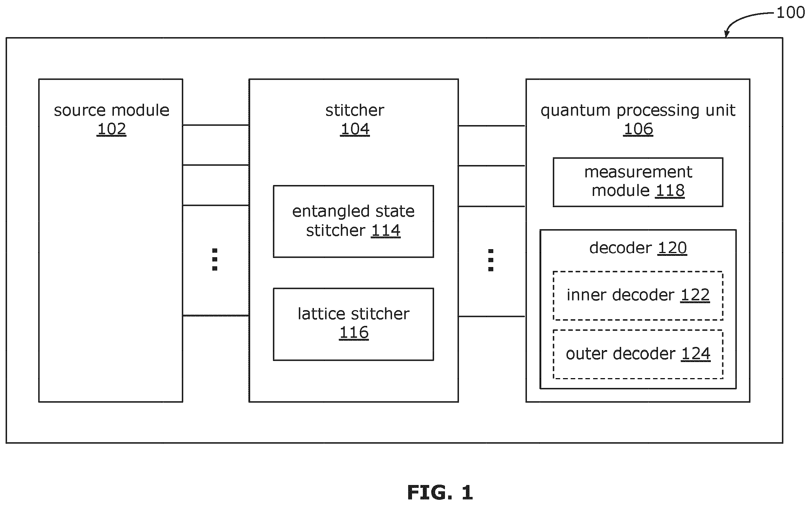

FIG. 1 illustrates a simplified system-level block diagram of an exemplary quantum computing system 100. Components of the system 100 described in more detail below can be configured to one or more of: create, generate, shape, measure, decode, or error-correct a selected entangled cluster state that serves as a resource for measurement-based fault tolerant quantum computation. For example, the system 100 may be a measurement-based quantum computer in the Raussendorf-Harrington-Goyal (RHG) model using continuous variable (CV) qubits. Although described in the context of a CV photonic quantum platform, it is understood that embodiments of the methods described herein are equally applicable to other quantum platforms including superconducting qubits, trapped ions, quantum annealing, and any other quantum platforms requiring quantum error correction to be performed.

In some embodiments, the system 100 includes a source module 102, a stitcher 104, and a quantum processing unit (QPU) 106. Each of the source module 102, the stitcher 104, and the QPU 106 represents logical functionality that can be implemented exclusively via hardware, exclusively via software, or via a combination of hardware and software. Further, the functional delineation between the separate elements within the system 100 may only be a conceptual representation of the overall operation of the system 100.

The source module 102 is configured to generate a plurality of input quantum states. In one exemplary embodiment, the source module 102 may include a plurality of Gaussian Boson Sampling (GBS) sources each configured to generate a continuous variable (CV) state of light, such as a Gottesman-Kitaev-Preskill (GKP) state. Data is mapped onto the generated CV states. GKP encoding was e.g. disclosed in "Encoding a qubit in an Oscillator" by D. Gottesman et al, Physical Review A, vol. 64, art. 012310 (2001).

Generation of a high-fidelity GKP state from a single GBS device is non-deterministic. However, the outputs of multiple GBS sources may be multiplexed to obtain higher rates and fidelities of state generation. In some single GBS sources, squeezed states of light in a few optical modes are passed through at least an interferometer before all but one of the modes are measured using photon-number-resolving (PNR) detectors. The PNR measurement is the non-Gaussian resource that allows for exotic wavefunctions to be produced. The multiplexing of GBS devices can be used to exploit the non-Gaussian resource of PNR detectors and can generate arbitrary logical single-qubit states for bosonic encodings such as those of the GKP and cat basis. "Multiplexing," as used herein, refers to the use of multiple probabilistic state devices in parallel, and the routing of a successfully generated CV state of light in any of these devices to the output. For example, a multiplexer, including a network of reconfigurable beamsplitters heralded on the PNR outcomes, shuttles the output of a successful GBS source to the next component. In the event that all GBS sources attached to a given MUX fail, the output of the MUX can be "swapped out" for a squeezed state of light, which can be produced deterministically. GBS source modules were e.g. disclosed in US11341428B2 ("Scalable photonic quantum computing with hybrid resource states"; hereinafter [Bourassa]).

As an example, in the ideal (lossless) case, when using three optical modes, a specific PNR pattern - e.g., occurring with a probability of ~0.1% - heralds a state with ~96% fidelity to a GKP |0〉 state with ~10 dB of squeezing and a peak spacing of $2 \sqrt{π}$. Since these sources are probabilistic (albeit heralded), many copies of GBS circuits can be used in parallel to boost the probability of a GKP state being generated. As used herein, for a desired state to be "heralded" means that a device provides a signal that the desired state has been successfully generated / produced.

In a further embodiment, the source module 102 may be configured to generate input quantum states through a breeding network, as e.g. disclosed in US2024346357A1 ("Generation of Gottesman-Kitaev-Preskill (GKP) states based on multi-peak quantum states of light"; hereinafter [Alexander]).

In some embodiments, the source module 102 may include a local pulse train generator. The local pulse train generator is configured to generate a train of local optical pulses that are also referred to as a local oscillator (LO) signal that is operably coupled to elements of the system 100, such as QPU 106, and particularly to the optical detectors (e.g., homodyne detectors) used for projective measurements in the generation of multimode entanglement and for measurement-based quantum computation.

A steady supply of CV states that include both encoded bosonic qubits and squeezed vacuum states may be generated by the source module 102 and sent to the stitcher 104 via a network of optical connections. In some embodiments, the source module 102, the stitcher 104, and the QPU 106 are either partially or entirely implemented on photonic integrated circuits (PICs), and the optical network may be implemented using optical fibers compatible with existing optical technologies, which may have a lower level of propagation loss compared to on-chip waveguides.

The states generated by the source module 102 are provided to the stitcher 104, which is configured to stitch the input states into a lattice structure in accordance with a specific encoding scheme. In some embodiments, the stitcher 104 can interfere these states, such as through a network of static beamsplitters with phase delays, before sending/routing the states to the QPU 106 to be processed for error correction.

The stitcher 104 may be conceptualized as incorporating an entangled state stitcher 114 and a lattice stitcher 116. As used herein, "stitching" refers to the creation/imposition of entanglement between different modes at the same or neighboring lattice sites. For example, during operation of the system 100, non-deterministically generated encoded qubits and non-Gaussian states of light can be stitched into a random but known subset of the sites (by virtue of them being generated at random subset of locations, while not being generated at other locations), while the remaining sites are populated with deterministically generated Gaussian states, such as squeezed vacuum states for example. An indication of whether or not a location is within the subset of the sites is provided. The encoded qubits carry the quantum information and are used for quantum error correction. Higher dimensional multi-mode entangled states were e.g. disclosed in [Bourassa].

The entangled state stitcher 114 is configured to stitch, or to entangle, through static linear-optical circuit components including beamsplitters (for example, static 50:50 beamsplitters), pairs of generated CV states into a two-mode entangled CV state, which is also referred to herein as a resource state. Depending on the choices of the two CV states that are entangled, a variety of different resource states can be implemented. For example, the resource state may include the cases where (a) both modes are suitable squeezed states (i.e., an entangled two-mode squeezed state); (b) one mode is a squeezed state and one mode is a selected GKP state (i.e., a hybrid two-mode entangled state), or (c) both modes are selected GKP states (i.e., a two-mode entangled GKP state).

The lattice stitcher 116 may be configured to stitch the resource states from the entangled state stitcher 114 into a higher dimensional (i.e., three (3) dimensions or higher of temporal, spatial, or a hybrid of spatial-temporal dimensions) multimode entangled state, including states that are suitable for quantum error correction and performing measurements. The lattice stitcher 116 may further be conceptualized as including a temporal stitcher and a spatial stitcher (not shown). The temporal stitcher may be configured to implement delay line loops and chain qubits together as they are received. The spatial stitcher may be configured to entangle outputs from the temporal stitcher in the spatial domain to produce higher-dimensional hybrid resource states. An exemplary 3-dimensional lattice structure of a multimode entangled state suitable for quantum error correction with decoding methods described herein is the Raussendorf-Harrington-Goyal (RHG) lattice. The RHG lattice is suitable for implementing the fault-tolerant version of a class of quantum error correction codes, in particular surface codes. One or more other lattice structures suitable for fault-tolerant quantum computing can also be generated, depending on the choice of quantum error correction code, such as quantum LDPC codes, using the quantum circuit configuration set forth herein. In some embodiments, the lattice stitcher 116 is configured to stitch a plurality of input resource states into a macronode that forms one lattice vertex of a higher-dimensional multimode entangled state.

Measurements can be performed on the higher dimensional multimode entangled state by a measurement module 118 of the QPU 106 to provide electric field quadrature information (e.g., the position or amplitude quadrature referred to herein as the "*q*-quadrature" and the momentum or phase quadrature referred to herein as the "*p*-quadrature"). The measurements are performed by one or more optical detectors of the measurement module 118. In some embodiments, the optical detectors are homodyne detectors which can be used to perform measurements on each macronode to reduce each macronode into a single node with multiple edges. The measurement outcomes can be used by the quantum computing system to perform error correction and can also be utilized by the system to perform measurement-based quantum computation (MBQC). The optical detectors, (i.e., homodyne detectors) may be configured to perform quadrature measurements by interfering the optical modes of an input entangled resource state with the train of local optical pulses on a beamsplitter and detecting the optical power difference of the two beam splitter outputs as an indication of the modal property(ies) of the quantum state of the given optical pulse. The measurement outcomes collected on the multimode entangled states (i.e., at the physical hardware layer) can be processed together to implement one or more aspects of an error correction code.

The measurement results are processed for quantum error correction in a decoder 120 in QPU 106. The decoder 120 is implemented in hardware and includes one or more electronic circuits. In some embodiments, the electronic circuits can include an integrated circuit such as an application-specific integrated circuit (ASIC) or a field-programmable gate array (FPGA). In some embodiments, the decoder 120 can be implemented in a combination of hardware and software. The quantum error correction procedure takes as input the measurement outcomes that have been realized to perform the logical operations, computes the syndrome data from the measurement outcomes, and outputs a reliable recovery operator. As used herein, "syndrome data" refers to the information computed from the outcomes of measurements performed to determine whether an error has occurred, and "recovery operator" refers to a unitary quantum operator that recovers the original codeword from an erroneous state. "Reliable" refers to outcomes obtained by performing such a measurement multiple times and polling over the outcomes to reduce the sensitivity of the outcomes to imperfections in the measurements. The error correction procedure includes the use of the decoder 120 to process the measurement data.

The decoder 120 can receive quadrature readouts from the measurement module 118 and can send LO phase updates to the measurement module 118 (e.g., to define or set which quadrature the homodyne detector is to measure). The QPU 106 can also receive instructional programs and can output results.

In some embodiments, operations of the decoder 120 may be conceptualized as including a first, or inner, decoder 122 and a second, or outer, decoder 124.

### Noise Model

In some embodiments, a generated cluster state is populated by two types of states discussed earlier herein: the encoded GKP |+〉 state and the momentum-squeezed state. The position wavefunction of the ideal GKP |+〉 state is: ${\left|+\right〉}_{gkp} = {\sum }_{n = - ∞}^{∞} {\left|n\sqrt{π}\right〉}_{q} ,$ where | ·〉_{q} corresponds to a position eigenstate, while the ideal GKP |-〉 state is: ${\left|-\right〉}_{gkp} = {\sum }_{n = - ∞}^{∞} {\left(-1\right)}^{n} {\left|n\sqrt{π}\right〉}_{q} .$ To model a state initialization error, a Gaussian white noise channel can be given by: ${N}_{Y} \left(\hat{ρ}\right) = \int \frac{{d}^{2} ξ}{π \sqrt{det \left(Y\right)}} exp \left[-\frac{1}{2}{ξ}^{T}{Y}^{- 1}ξ\right] D \left(ξ\right) \hat{ρ} D {\left(ξ\right)}^{†} ,$
where *Y* is the noise matrix, *ρ̂* is the density matrix of the state, and the Weyl-Heisenberg displacement operator is defined as *D*(*ξ*) = *exp*[*iξ^{T}Ωr̂*] , where *ξ* = (*ξ_{q}, ξₚ*)*^{T}* ∈ *R*² for a single mode, Ω is the anti-symmetric symplectic matrix, *r̂ =* (*q̂, p̂*)*^{T},* and the superscript *T* represents the transpose. For the GKP states and the momentum squeezed states, the corresponding noise matrices are given by: ${Y}_{gkp} = \frac{1}{2} \left[\begin{matrix}δ & 0 \\ 0 & δ\end{matrix}\right] , {Y}_{p} = \frac{1}{2} \left[\begin{matrix}{δ}^{- 1} & 0 \\ 0 & δ\end{matrix}\right] ,$
where *δ* is the scaled squeezing factor. Note that *δ* is a real number and can optionally be represented in units of decibels (dB) by *δ* [dB] = -10log₁₀ *δ*. Alternatively, to model the state initialization error, and given ideal |+〉_{gkp} states, the noise channels *N*_{*Y*_{gkp}} or *N_{Yₚ},* with probabilities 1 - *p*₀ and *p*₀, respectively, can be applied to the ideal |+〉_{gkp} states. This latter method approximates the realistic momentum state well in the position basis but has a periodic structure in momentum space.

There are several reasons to model the state preparation error with the Gaussian white noise channel of Equations (2) and (3). For example, many CV gates use a measurement-based squeezing operation that naturally leads to imperfections modeled as a Gaussian white noise channel. Furthermore, this type of noise is closely related to pure loss, and following a pure loss channel by an amplifier of the inverse strength leads to a Gaussian white noise channel. In settings where loss can be treated this way, such as in measurement imperfections, this relationship can play an important role.

The Gaussian white noise channel is readily described using the Heisenberg picture. Consider the quadrature operators of the *N*-modes, where *R̂* = (*q̂₁, q̂₂, ... , q̂_{N}, p̂₁, p̂*₂, *... , p̂_{N}*,)*^{T}.* The noise channel on each mode can be described as: $\hat{R} \to \hat{R} + Ξ ,$
where Ξ = (*ξ*_{*q*1}, *ξ*_{*q*2}, ... , *ξ_{qN}*, *ξ*_{*p*1}, *ξ*_{*p*2}, *... , ξ_{pN}*)*^{T}* are random variables, all drawn from the corresponding normal distributions associated with the state initialization errors. It is assumed that the initial means are all set to zero, i.e., 〈*R̂*〉 = 0. This picture is useful because often only displacement errors are simulated, rather than the actual wavefunction. As such, tracking the displacement errors can provide a direct and efficient way to simulate the system.

### Cluster State Initialization

In some embodiments, a vector of length 2*N* can first be initialized (where *N* is the number of modes), to store the means of the *q* and *p* quadrature displacement errors for each mode. Initially, the mean of every quadrature is 0. For each mode, with probability *p*₀, a momentum-squeezed state is prepared, and with probability (1 - *p*₀), a |+〉_{gkp} state is prepared. Next, CZ gates (e.g., "perfect" or "ideal" CZ gates) are applied according to the structure of the cluster state, i.e., wherever there is an edge between two nodes in the lattice. Some of the CZ gates may be inverted to match the CV Toric code convention.

Recall that the symplectic transformation for a CZ gate in the (*q*₁, *q*₂, *p*₁, *p*₂) basis ordering is given by: ${S}_{CZ} = \left[\begin{matrix}1 & 0 & 0 & 0 \\ 0 & 1 & 0 & 0 \\ 0 & 1 & 1 & 0 \\ 1 & 0 & 0 & 1\end{matrix}\right] ≡ \left[\begin{matrix}I & 0 \\ {A}_{2} & I\end{matrix}\right] ,$
where *I* is the identity matrix. Notice that *A*₂ is the *adjacency matrix* for the two modes. In other words, *A*₂ is a symmetric binary matrix whose *ij^{th}* entry is 1 if the two modes are connected by an edge, and 0 otherwise. For the application of CZ^{†}, it is presumed that *A*₂ → *-A*₂. (Note: The notation †, for a given gate, refers to its Hermitian conjugate.) Therefore, the symplectic matrix corresponding to the connection of all the optical modes into a cluster state is given by: $S = \left[\begin{matrix}I & 0 \\ A & I\end{matrix}\right] ,$
where now *A* is the *N* × *N* adjacency matrix of the corresponding graph, except with -1's where the CZ^{†} is applied. The initial noise matrix for all the modes is: ${Σ}_{0} = \left[\begin{matrix}{Σ}_{x} & 0 \\ 0 & \frac{δ}{2} I\end{matrix}\right] ,$
where Σ*ₓ* is a diagonal matrix with elements $\frac{1}{2} {δ}^{- 1}$ or $\frac{1}{2} δ$ depending on if the mode is p-squeezed or GKP, respectively. Thus, the full noise matrix evolves to: ${Σ}_{0} \to S {Σ}_{0} {S}^{T} = \left[\begin{matrix}{Σ}_{x} & {Σ}_{x} {A}^{T} \\ A {Σ}_{x} & \frac{δ}{2} I + A {Σ}_{x} {A}^{T}\end{matrix}\right] .$

Finally, the momentum values are measured. In some embodiments, only the momentum part of the noise matrix is considered, which is given by: ${Σ}_{p} : = \frac{δ}{2} I + A {Σ}_{x} {A}^{T} .$

Although some of the information on correlations in the noise matrix introduced by the CZ gates and the presence of *p*-squeezed states can be incorporated into the decoder, it can be valuable to identify an improved CV decoder or translator that acknowledges the noise matrix in Equation (9). Note that the translator *T* is a function that takes CV data and outputs binary data as though the CV modes are qubits, i.e., $T : {R}^{n} \to {\left\{0, 1\right\}}^{n} .$

To better illustrate the importance of such a translator (as in the inner decoder 122 described below), consider the example of a momentum-squeezed state at the center of a primal face, surrounded by four GKP states. A large amount of CV noise, of magnitude $\frac{{δ}^{- 1}}{2}$, is symmetrically distributed from the *q* quadrature of the momentum state to the *p* quadratures of the connected GKP states. Due to the periodicity of the GKP states, however, the net effect is either the identity gate or *Z* gates applied to all of the surrounding GKP states, which commutes with the stabilizers in the RHG lattice.

Thus, in some embodiments, a translator may be desired for the hybrid system configuration which takes into account the encoding phase of the computation, since this will be the same regardless of the ensuing logical operations of the computation. In other words, it is known which modes are GKP and *p*-squeezed states, and it is known where CZ gates have been applied to form the cluster state. If the distribution of *p*-homodyne outcomes were to be examined at this stage, the *p*-homodyne outcomes would be sampled from a periodic arrangement of Gaussian distributions, each with covariance Σ*ₚ*, and each Gaussian centered at a point $n \sqrt{π}$, where ***n*** are integer-valued vectors from a set that corresponds to the ideal state of the qubits.

Suppose the values ***p*** are obtained after the homodyne measurements. From the above, it is assumed that the candidate distributions that could have produced ***p*** are Gaussian distribution functions with covariance Σ*ₚ* and are centered at lattice points $n \sqrt{π}$. The responsibility of a given lattice point for the result ***p*** is given by: $r = exp \left[-{\left(n\sqrt{π}-p\right)}^{T}{Σ}_{p}^{- 1}\left(n\sqrt{π}-p\right)\right] .$

Thus, the lattice point which was most likely to have produced the point ***p*** is given by: ${n}_{IQP} = arg {min}_{p} {\left(n\sqrt{π}-p\right)}^{T} {Σ}_{p}^{- 1} \left(n\sqrt{π}-p\right) ,$
where the subscript IQP is selected to indicate that this is an integer quadratic program, i.e., a minimization of a quadratic function over an integer domain. In some embodiments, for simplicity, a standard approximation may be used in which all peaks in the GKP state have equal weight. In some other embodiments, an envelope that weights peaks differently may be used, in which case this information could also be included in the calculation of the responsibility. In general, IQPs are NP-hard, so the heuristic strategy should be computationally tractable.

In further embodiments, the cluster initialization may be implemented using one or more beamsplitter, as e.g. disclosed in [Alexander].

### Inner Decoder

The inner decoder 122 may be configured to process real-valued homodyne measurement outcomes to obtain binary outcomes representing bit values, i.e., *Rⁿ* → {0,1}*ⁿ*. The syndrome data obtained from these binary outcomes can then be combined with the probability of the binary outcomes being in error and used in the subsequent decoding procedure of the outer decoder described in more detail below. The probability of the binary outcomes being in error is also referred to as "soft information" and is used by the outer decoder.

In some embodiments, a standard map from homodyne measurement outcomes to bit values is a binning function derived from the translational symmetry of the original GKP state, i.e., the perfect periodicity in the *q* and *p* directions. The |+〉 and |-〉 are GKP states that are each $2 \sqrt{π}$-periodic in momentum but shifted relative to each other by $\sqrt{π}$*.* As such, the homodyne outcomes can be placed into bins of width $\sqrt{π}$, associating with |+〉 the outcomes falling in even bins and with |-〉 for all the other values. While this binning procedure uses the original symmetry of the GKP states, it does not account for the correlations in the noise matrix introduced by the photonic controlled-Z ("CZ") gates and the presence of *p*-squeezed states. A CZ gate is a two-qubit gate that perform two-qubit operations. The truth table for a CZ gate is as follows:

| CZ Gate | |
|---|---|
| IN | OUT |
| \|00〉 | \|00〉 |
| \|01〉 | \|01〉 |
| \|10〉 | \|10〉 |
| \|11〉 | -\|11〉 |

In some embodiments, the inner decoder 122 may be configured to receive, as input, homodyne measurement outcome vectors and a noise model. The inner decoder 122 may then be configured to identify directions that are noisy and directions that are not noisy based on the inputs in terms of error probability values. Then the inner decoder 122 may be configured to perform a suitable change of basis to the homodyne measurement data to obtain CV results for joint quadratures, a smaller number of which have reduced noise. In particular, an integer-valued transformation would allow for certain consistency checks (e.g., parity) when making an estimation for the *p*-space lattice point *n*. A binning operation may then be applied along the new directions to round results to the nearest ideal peak positions, while taking into account the self-consistency of the results (e.g., parity). The change of basis can be undone to return a candidate lattice point $n \sqrt{π}$*.* A binary string may then be obtained by taking *n* mod 2 to yield the interpreted qubit measurement outcomes.

### Outer Decoder

The outer decoder 124 receives the interpreted qubit measurement outcomes from the inner decoder 122 and applies error correction. In some embodiments, the outer decoder 124 implements an OSD algorithm. The OSD algorithm is a decoding technique that exploits the fact that the error patterns in a received signal are often correlated, and therefore, by examining the received inputs in a certain order, the algorithm can efficiently identify and correct errors. OSD may be capable of handling a wide range of signal-to-noise ratio (SNR) values, making it useful in both low- and high-SNR scenarios. OSD can also handle a variety of code rates and constraint lengths, making it a versatile decoding technique for different types of error correction codes.

However, some of the above-mentioned advantages of the OSD algorithm come at the cost of comparatively poor complexity, which is correlated with computational time and memory required. Specifically, OSD's poor complexity scales as *O*(*n*³), where *n* is the size of the input vector to the OSD. The primary cause of the computational bottleneck lies in part due to the computation of matrix inverses. The inverse of a matrix is computed using Gaussian elimination, which quickly becomes computationally expensive as the size of the matrix increases. In some embodiments, the methods and systems provided herein leverage the sparse nature of the matrices involved to perform Gaussian elimination that only involves the manipulation of a subset of the matrix elements, thereby providing a more computationally efficient OSD algorithm.

### Error Correction

Quantum error correction involves tandem encoding and decoding schemes that not only permit detecting an error occurrence, but also enable recovery of the original quantum information at an acceptable rate. In general, quantum error correction, similar to classical error correction, begins by encoding quantum information over multiple redundant qubits in a particular arrangement in accordance with an encoding scheme. Noise induces changes of varying degrees to the encoded quantum state. The encoded quantum state subjected to noise is then decoded to generate a value that takes into account how an error would impact the encoded information. The decoding utilizes parity measurements, also called stabilizers, where ancillary qubits are entangled with the computational qubits, and are measured to produce an error syndrome that allows the detection of indirect signs of a detectable error. A stabilizer code is defined as the set of all simultaneous +1 eigenstates of a commutative group of operators, called a stabilizer group. For example, Pauli stabilizer codes, which are commonly used in quantum error correction, are codes in which the stabilizer group is a subset of the Pauli group. The syndrome (i.e., the outcomes of the stabilizer measurements acting on the qubits) must then be decoded, which provides a recovery operator that can be used to correct for qubit errors. Types of errors that need to be corrected include bit-flip errors (equivalent to an X-gate acting on a qubit) and phase-flip errors (equivalent to a Z-gate acting on a qubit). Hence, error recovery may be performed to attempt to recover the original encoded information.

Let *I* be the identity operator, *X* be the Pauli*-X* operator, *Y* be the Pauli*-Y* operator, and *Z* be the Pauli*-Z* operator. One can then consider a Pauli-to-binary (P2B) mapping (also called symplectic representation, or tableau representation), by which *I* → [0|0], *X* → [110], *Y* → [1|1], and *Z* → [0|1]. A parity check matrix for a classical linear code is a matrix *H* with the property that *Hz* = 0 if and only if *z* is a codeword. In other words, a parity check matrix verifies whether a received message is a valid codeword or not. Based on the foregoing, a parity check matrix for a quantum code may then be defined as *H* → [*H_{X}*|*H_{Z}*], where *H_{X}* and *H_{Z}* are obtained from stabilizers using P2B mapping. By way of a non-limiting example, a 5-qubit linear code may have a check matrix defined as: $\begin{matrix}XZZXI \to \left[\left.10010\right|01100\right] \\ IXZZX \to \left[\left.01001\right|00110\right] \\ XIXZZ \to \left[\left.10100\right|00011\right] \\ ZXIXZ \to \left[\left.01010\right|10001\right]\end{matrix} ⇒ H = \left[\left.\begin{matrix}1 & 0 & 0 & 1 & 0 \\ 0 & 1 & 0 & 0 & 1 \\ 1 & 0 & 1 & 0 & 0 \\ 0 & 1 & 0 & 1 & 0\end{matrix}\right|\begin{matrix}0 & 1 & 1 & 0 & 0 \\ 0 & 0 & 1 & 1 & 0 \\ 0 & 0 & 0 & 1 & 1 \\ 1 & 0 & 0 & 0 & 1\end{matrix}\right] = \left[\left.{H}_{X}\right|{H}_{Z}\right] .$

Syndrome *s* can then be computed based on whether the error commutes or anticommutes with the stabilizer generators as $e = \left[\left.{e}_{X}\right|{e}_{Z}\right] \to s = {H}_{X} {e}_{Z}^{T} + {H}_{Z} {e}_{X}^{T}$*,* where *e* = [*e_{X}*|*e_{Z}*] is the error.

When *e =* [*e_{X}*|*e_{Z}*] is the P2B mapping of a Pauli operator L that transforms one codeword to another, the syndrome of *e is* 0, i.e., $s = {H}_{X} {e}_{Z}^{T} + {H}_{Z} {e}_{X}^{T} = 0$.

LDPC codes that are used to construct the higher dimensional lattice structure in some embodiments as described above could significantly reduce the overhead required for fault-tolerant quantum computation. Most of the widely studied LDPC codes belong to the class of Calderbank-Shor-Steane (CSS) codes. CSS codes are a particular class of error correcting codes that use stabilizer generators of only *X*-operators or only *Z*-operators. In other words, CSS codes are capable of performing bit-flip error correction and phase-flip error correction separately. Thus, in some embodiments, the correlations between bit-flip and phase-flip errors may be neglected and bit-flip and phase-flip error correction may be performed independently of one another using the parity check matrices *H_{Z}* and *H_{X}* of the quantum code, respectively. The check matrix and the syndrome determination of CSS codes may be expressed in the form: $H = \left[\left.\begin{matrix}{H}_{X} \\ 0\end{matrix}\right|\begin{matrix}0 \\ {H}_{Z}\end{matrix}\right]$ $e = \left[\left.{e}_{X}\right|{e}_{Z}\right] \to \begin{matrix}{s}_{Z} = {H}_{X} {e}_{Z}^{T} \\ {s}_{X} = {H}_{Z} {e}_{X}^{T}\end{matrix} ,$ where *e_{X}* is the *X*-component of the error, *e_{Z}* is the *Z*-component of the error, *s_{X}* is the *X-*component of the syndrome, and *s_{Z}* is the *Z*-component of the syndrome. Thus, syndromes for *X-* and *Z*-errors are computed separately, and their respective errors can be estimated separately (at the cost of dropping possible correlations in noise, particularly *Y*-errors). In the context of photonic qubits, this corresponds to performing phase-flip error correction (*H_{X}*) and bit-flip error correction (*H_{Z}*) separately, while ignoring correlations between the two.

As an example, consider an 8-qubit Toric code of distance *d* = 2: $\begin{matrix}XXXIIIXI \to \left[\left.11100010\right|00000000\right] \\ XXIXIIIX \to \left[\left.11010001\right|00000000\right] \\ IIXIXXXI \to \left[\left.00101110\right|00000000\right] \\ IIIXXXIX \to \left[\left.00011101\right|00000000\right] \\ ZIZZZIII \to \left[\left.00000000\right|10111000\right] \\ IZZZIZII \to \left[\left.00000000\right|01110100\right] \\ ZIIIZIZZ \to \left[\left.00000000\right|10001011\right] \\ IZIIIZZZ \to \left[\left.00000000\right|01000111\right]\end{matrix} ⇒ H = \left[\begin{matrix}11100010 \\ 11010001 \\ 00101110 \\ 00011101 \\ 00000000 \\ 00000000 \\ 00000000 \\ 00000000\end{matrix} \begin{matrix}00000000 \\ 00000000 \\ 00000000 \\ 00000000 \\ 10111000 \\ 01110100 \\ 10001011 \\ 01000111\end{matrix}\right] .$

The distance is defined as the weight of the lowest-weight operator that commutes with all stabilizers but is not itself a stabilizer (for example, for the stabilizers listed below, *ZZIIIIII* has weight 2 and commutes with all stabilizers). In other words, the distance of the linear code is the minimum number of single qubit Pauli operations performed to transform one codeword to another.

LDPC codes are characterized with having sparse check matrices, which have a low density of 1's. This corresponds to both the number of qubits in each stabilizer and the number of stabilizer measurements acting on a qubit being bounded above by a small constant value independent of code size. Code size refers to the code length, i.e., the number of qubits in the quantum error correction code. Hence, decoders can leverage the sparse nature of the check matrices to improve the computational efficiency. Examples of LDPC codes include surface codes and the color code. Note that a code can be both a CSS code and an LDPC code, the two are not mutually exclusive, and CSS LDPC codes are of particular interest in quantum error correction research.

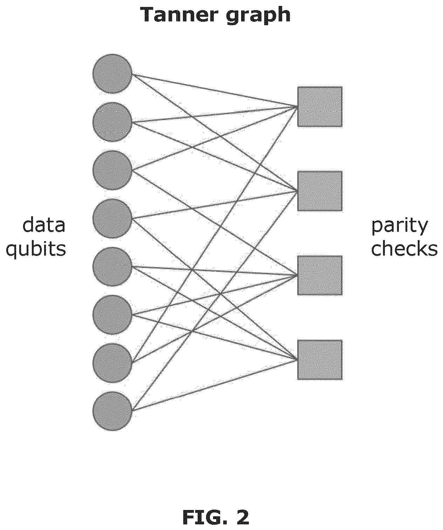

The relationship between data qubits and parity checks can also be represented graphically (as opposed to the matrix form of the parity check matrix *H*) by a Tanner graph, an example of which is shown in FIG. 2. As shown, data qubit node *i* is connected to parity check node *j* if *H_{X}*[*j, i*] = 1 *or H_{Z}*[*j, i*] *=* 1. Note that in some embodiments, such as in the case of CSS codes, the Tanner graphs for *H_{X}* and *H_{Z}* may be separate and distinct from each other.

### BP-OSD

BP is an iterative decoder that may be used with finite length quantum low-density parity-check codes. This type of iterative decoder is desirable as its hardware complexity scales as *O*(*n*), where *n* is the size of the input to the BP decoder (i.e., linearly with the number of physical qubits). However, it has been found that BP decoders fail to converge in some instances due to the creation of trapping sets when the Tanner graph of the code has short cycles. Trapping set creation within LDPC codes was e.g. disclosed in "Trapping sets of quantum LDPC codes" by N. Raveendran and B. Vasić, Quantum, vol. 5, pp. 562 (2021).

In comparison, OSD is a non-iterative decoding technique, and is thus immune from trapping sets that plague the iterative decoding of LDPC codes. However, this comes at the expense of a worst-case complexity of *O*(*n*³). Accordingly, the application of OSD is typically limited to short-length codes.

In some embodiments, the outer decoder implements a hybrid BP-OSD algorithm. The hybrid approach is able to take advantage of the linear complexity of BP combined with the robustness of OSD by using the BP decoder to improve upon, or update, the physical error probability obtained from homodyne detection, and using OSD as a post-processing step for when BP fails to converge, such as when BP encounters a trapping set or stopping set. Trapping sets and stopping sets were e.g. disclosed in "Error floors of LDPC codes" by T. Richardson, Proceedings of the 41st Annual Allerton Conference on Communication, Control, and Computing, pp. 1426-1435 (2003). The OSD may be configured to use the updated physical error probability-based weights from the BP decoder which may improve the overall decoding performance compared to embodiments where the OSD is deployed without the BP decoder. Further, the disclosure herein provides an improved implementation of OSD that leverages the sparse nature of the check matrices to perform matrix operations and thereby reduce the complexity of the OSD.

The BP decoder is configured to combine the stabilizer measurement outcomes based on the binary outcomes from the inner decoder and the stabilizer-based relations between qubit states depicted in the Tanner graph to update the error probability weights. In some embodiments, the BP decoder may be implemented using a hardware-efficient algorithm, such as the min-sum algorithm (MSA), which is an approximation of the BP algorithm. An MSA implementation for the BP decoder was e.g. disclosed in "Finite rate QLDPC-GKP coding scheme that surpasses the CSS Hamming bound" by N. Raveendran et al, Quantum, vol. 6, pp. 767 (2022). Upon detecting a failure to converge by the BP decoder, such as in cases of trapping sets and stopping sets, the post processing OSD is invoked.

### OSD

The OSD in accordance with the present disclosure is described below in the context of phase-flip error correction. However, as noted above, the decoder is also applicable in determining bit-flip errors.

In some embodiments, the OSD receives as input: stabilizer data in the form of either a parity check matrix (*H_{X}* or *H_{Z}*) or a Tanner graph of the code for the parity check matrix of the code; a list of syndromes *s* that causes BP to fail to converge (i.e., due to trapping sets); a list of qubit error probability weights (which may correspond to the list of updated error probability weights at the end of BP decoding); and an optional higher-order OSD parameter *λ*. In some further embodiments, where the OSD is a standalone decoder, error probability-based weights are generated from measurements.

Let *H_{X}* be the *X*-check matrix of the code, *e* denote the error that occurred, and *s* denote the measured syndrome. Their relationship is as follows: ${H}_{X} {e}^{T} = {s}^{T} .$

As the error correction code has a positive code rate, *H_{X}* is not invertible. Hence, the inverse matrix of *H_{X}* cannot be easily obtained to obtain *e* from *s.* Let *ê* be an *n*-bit vector in the set of all *n*-bit vectors that satisfy *H_{X}ê^{T} = s^{T}.* There may be more than one *n*-bit vector *ê* that satisfies Equation (13). Hence, one decoding strategy is to determine the most likely error *ẽ* from the set of all *ê* (i.e., the *n*-bit vector *ê* with the highest probability of occurrence of an error).

Let *r* be the rank of the parity check matrix *H_{X}.* Then, assuming that the leftmost *r* columns of the check matrix are linearly independent and the topmost *r* rows of the matrix are also linearly independent, the check matrix *H_{X}* can be expressed in terms of its submatrices as follows: ${H}_{X} = \left[\begin{matrix}{H}_{S} & {H}_{T} \\ {H}_{U} & {H}_{V}\end{matrix}\right] ,$ where *H_{S}* is a full-rank matrix of size *r.* Note that if *H_{X}* is a full-rank matrix (*r* = *m*), where *m* is the number of rows of *H_{X},* then *H_{U} = H_{V}* = 0. As both *H_{U}* and *H_{V}* only contain linearly dependent rows, Equations (13) and (14) may be combined as: ${H}_{X} {\hat{e}}^{T} = {s}^{T} , \left[\begin{matrix}{H}_{S} & {H}_{T} \\ {H}_{U} & {H}_{V}\end{matrix}\right] {\hat{e}}^{T} = {s}^{T} , \left[{H}_{S} {H}_{T}\right] {\hat{e}}^{T} = {s}^{T} .$

Let *ê* = [*ê_{S} ê_{T}*]*,* where *ê_{S}* and *ê_{T}* are the first *r* and the remaining (*n* - *r*) bits of *ê*. Then Equation (15) may be expressed as: ${H}_{S} {{\hat{e}}_{S}}^{T} + {H}_{T} {{\hat{e}}_{T}}^{T} = {s}^{T} .$

Thus, it may be conceptualized that two *ê*-based components contribute to the syndrome of the error, namely, *H_{S}ê_{S}^{T}* and *H_{T}ê_{T}^{T}.* Accordingly, if a value can be assigned to *ê_{T},* then the corresponding *ê_{S}* can be determined as: ${\hat{e}}_{S}^{T} = {{H}_{S}}^{- 1} \left({s}^{T}-{H}_{T}{{\hat{e}}_{T}}^{T}\right) = {{H}_{S}}^{- 1} {s}^{T} - {{H}_{S}}^{- 1} {H}_{T} {{\hat{e}}_{T}}^{T} .$

Based on the number of non-zero elements (i.e., the number of binary 1's) in the term *ê_{T},* the order of the OSD, *k,* is defined.

For a Oth-order OSD (i.e., no 1's in *ê_{T}*), the *ê_{T}* term equals 0; and hence the error term is equal to the *ê_{S}* term as: ${{\hat{e}}_{S}}^{{\left(0\right)}^{T}} = {{\hat{e}}_{S}}^{T} = {{H}_{S}}^{- 1} {s}^{T} .$

Thus, for Oth-order OSD, the error recovery operator is derived from Equation (18).

In some embodiments, higher-order OSD may provide a more accurate determination of *ê_{S}.* For higher-order OSD (i.e., one or more 1's in *ê_{T}),* permutations of binary bits for the value of *ê_{T}* are considered in determining which permutation yields the highest error probability. This approach is also referred to as combination sweep herein. Particularly, Equations (17) and (18) may be expressed as: $\begin{matrix}{{\hat{e}}_{S}}^{T} = {{H}_{S}}^{- 1} {s}^{T} - {{H}_{S}}^{- 1} {H}_{T} {{\hat{e}}_{T}}^{T} , \\ {{\hat{e}}_{S}}^{T} = {{\hat{e}}_{S}}^{{\left(0\right)}^{T}} - {{H}_{S}}^{- 1} {H}_{T} {{\hat{e}}_{T}}^{T} .\end{matrix}$

In some embodiments, all permutations of *ê_{T}* where each permutation comprises of (*n - r*) binary bits having *l* non-zero bits may be iteratively applied to Equation (19) to yield corresponding error values *ê_{S}.* The resulting error recovery operator is the vector [*ê_{S} ê_{T}*]*.* The corresponding error probability weight may be determined by summing up the error probability weights of each qubit represented by a non-zero element in the vector [*ê_{S} ê_{T}*]. The term *ê_{T}* is also referred to as the corrective error term herein given its effect on the higher-order error estimate.

As may be appreciated, the iteration of all possible binary permutations of *ê_{T}* may be computationally expensive. Thus, in some further embodiments, an optional higher-order OSD parameter *λ* is received by the OSD to determine an estimated *ê_{T}.* Instead of a binary vector length of (*n* - *r*)-bits, the user may specify a vector length of *λ* where *λ <* (*n* - *r*). Additionally, the number of non-zero elements *k* within the *λ* bits may also be specified. Accordingly, instead of iterating over binary vectors of (*n* - *r*) bits having *k* non-zero elements, the OSD may instead iterate over binary vectors of *λ* bits having *k* non-zero elements. This method permits decreased computational resources and time while still maintaining an acceptable error threshold. The last *(n - r - k*) elements of *ê_{T}* are considered to be 0, i.e., these qubits are assumed to be error-free.

In arriving at Equation (14) above, it is assumed that the leftmost *r* columns of the check matrix *H_{X}* are linearly independent and the topmost *r* rows of *H_{X}* are also linearly independent. In some embodiments, the received stabilizer data associated with the parity check matrix (i.e., either the Tanner graph representing the check matrix or the check matrix itself) are not in such form. Thus, in such cases, the OSD generates a sparse matrix based on columns of the stabilizer data reordered according to the error probability weights. In some embodiments, the columns are arranged from the least error probability weights to the highest error probability weights. The error probability weights *wₑ* may be determined by the inner decoder as: ${w}_{e} = log \frac{1 - p}{p} ,$ where *p* is the error probability as determined by the inner decoder, and are further processed by the BP decoder before being used in OSD. It can be seen that qubits with higher error probability will have a lower error probability weight, and qubits with lower error probability will have a higher error probability weight.

The rows of the sparse matrix are the reordered rows of the check matrix derived from the stabilizer data. In some embodiments, the rows are reordered such that the resulting sparse matrix is of upper triangular form. All the linearly dependent rows would essentially form matrices *H_{U}* and *H_{V}* in Equation (14), whereas the linearly independent rows, ordered based on the first non-zero element in each row, would form *H_{S}* and *H_{T}.*

In some further embodiments, instead of physically rearranging the columns and rows of the check matrix to derive the sparse matrix, the row and column ordering are simply stored (i.e., in a vector or a table). All subsequent matrix operations are performed based on the stored ordering of the rows and columns. The qubit error probability weights are also reordered based on one or more of the row and column ordering.

The resulting sparse matrix may then be organized in the form of the check matrix expressed in Equation (15), namely [*H_{S} H_{T}* ]*,* where *H_{S}* and *H_{T}* are submatrices of the sparse matrix with *H_{S}* being a full-rank matrix of size r.

Next, in view of Equations (18) and (19) above, the inverse matrix *H_{S}*⁻¹ of the sub-matrix *H_{S}* is to be determined. Recall that *H_{S}* is a full-rank square matrix comprised of *r* linearly independent rows and *r* linearly independent columns. Thus, one method of obtaining the inverse matrix of *H_{S}* is Gaussian elimination, which is a known method of row reduction for solving systems of linear equations. It is this inverse matrix determination step that renders the OSD to have a complexity of *O*(*n*³) as shown below.

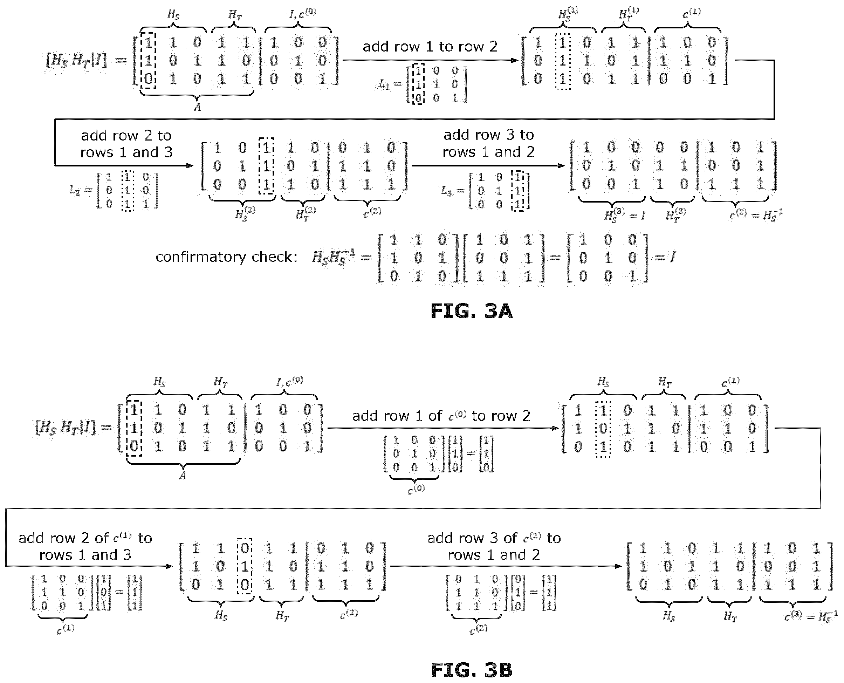

To illustrate operations of the standard Gaussian elimination method, consider a full-rank 3 × 5 matrix *A* having a rank of 3 (i.e., the first 3 columns being linearly independent) as shown in FIG. 3A. This serves as a valid example as any linearly dependent rows in *A* would be converted into zero rows as a result of the Gaussian elimination method. As Gaussian elimination involves row permutations and row additions, the column permutation that permutes the left-most *r* linearly independent columns to the first *r* columns of the matrix can be applied either at the start or at the end of Gaussian elimination. Thus, the matrix *A* may be organized into the form shown in Equation (14). Recall as matrix *A* is a full-rank matrix, submatrices *H_{U}* and *H_{V}* are zero-matrices. Thus, matrix *A* is of the form *A =* [*H_{S} H_{T}* ]*,* where *H_{S}* is a 3 × 3 invertible matrix, and *H_{T}* includes the two rightmost columns of matrix *A.*

Matrix *A* is horizontally concatenated with an identity matrix *I* of size *r,* which in this example is 3. To determine *H_{S}⁻¹,* the Gaussian elimination method transforms, through linear transformations, *A =* [*H_{S} H_{T}* ] to *A =* [*I B* ], where *B* is some binary matrix. Applying the same linear transformations onto the concatenated matrix (i.e., [*H_{S} H_{T}* |*I*], the identity matrix *I* becomes the inverse matrix of *H_{S}* (i.e., [*I B* |*H_{S}*⁻¹] as *H_{S}* is transformed into the identity matrix *I*. Let *L* be the linear transformation that corresponds to the row exchanges and row additions performed during the Gaussian elimination method. The above can then be formulated as: $\begin{matrix}L \left[\left.{H}_{S} {H}_{T}\right|I\right] = \left[\left.I B\right|{{H}_{S}}^{- 1}\right] , \\ \left[L\left.{H}_{S} {LH}_{T}\right|L\right] = \left[\left.I B\right|{{H}_{S}}^{- 1}\right] .\end{matrix}$

From Equation (21), it follows that: $\begin{matrix}L = {{H}_{S}}^{- 1} , {LH}_{S} = I , {LH}_{T} = B \\ ⇒ {{H}_{S}}^{- 1} {H}_{T} = B .\end{matrix}$

The binary matrix *B* need not be computed for the purposes of obtaining the inverse of *H_{S}.* In terms of notation, let *L*₁ denote the linear transformation corresponding to the first step of the Gaussian elimination method, which may include row additions and/or row exchanges. Let *L*₁ transform [*H_{S} H_{T}* ] to [*H_{S}*⁽¹⁾ *H_{T}*⁽¹⁾ ] and identity matrix *I* to *C*⁽¹⁾, where *H_{S}*⁽¹⁾, *H_{T}*⁽¹⁾, and *C*⁽¹⁾ are intermediary binary matrices that have the same dimensions as *H_{S}, H_{T},* and *I*, respectively. Based on Equations (21) and (22), the linear transformation by *L*₁ may be expressed as: $\begin{matrix}{L}_{1} \left[{H}_{S} {H}_{T}\left|I\right.\right] = \left[{{H}_{S}}^{\left(1\right)} {{H}_{T}}^{\left(1\right)}\left|{C}^{\left(1\right)}\right.\right] \\ ⇒ \left[{L}_{1}{H}_{S} {L}_{1}{H}_{T}\left|{L}_{1}\right.\right] = \left[{{H}_{S}}^{\left(1\right)} {{H}_{T}}^{\left(1\right)}\left|{C}^{\left(1\right)}\right.\right] \\ ⇒ {L}_{1} = {C}^{\left(1\right)} , {L}_{1} {H}_{S} = {{H}_{S}}^{\left(1\right)} , {L}_{1} {H}_{T} = {{H}_{T}}^{\left(1\right)} Equation \left(23\right) \\ ⇒ {C}^{\left(1\right)} {H}_{S} = {{H}_{S}}^{\left(1\right)} , {C}^{\left(1\right)} {H}_{T} = {{H}_{T}}^{\left(1\right)} . Equation \left(24\right)\end{matrix}$

Accordingly, in a first transformation *L*₁, the first column of *H_{S},* namely $\left[\begin{matrix}1 \\ 1 \\ 0\end{matrix}\right]$, is to be transformed into the first column of the identity matrix, namely $\left[\begin{matrix}1 \\ 0 \\ 0\end{matrix}\right]$. In order to eliminate the non-zero first element in row 2, row 1 is to be applied (i.e., by addition or subtraction) to row 2 as indicated by ${L}_{1} . = \left[\begin{matrix}1 & 0 & 0 \\ 1 & 1 & 0 \\ 0 & 0 & 1\end{matrix}\right]$. According to Equations (23) and (24), each of the intermediary matrices *H_{S}*⁽¹⁾, *H_{T}*⁽¹⁾, and *C*⁽¹⁾ may be determined by their respective matrix multiplication with *L*₁. The matrix multiplications in this step alone may result in 18 bit-flip operations, where each bit-flip operation involves changing an initial 0-bit to a 1-bit. Even with optimization, such as by performing row permutations and additions via sparse matrix implementations, at least 7 bit-flip operations may be needed to determine *H_{S}*⁽¹⁾ as shown in FIG. 3A.

In a second transformation, the second column of the intermediary matrix *H_{S}*⁽¹⁾, namely $\left[\begin{matrix}1 \\ 1 \\ 1\end{matrix}\right]$, is to be converted to the second column of the identity matrix form, namely $\left[\begin{matrix}0 \\ 1 \\ 0\end{matrix}\right]$. Hence, the transformations of applying row 2 to each of row 1 and row 3 is represented by ${L}_{2} = \left[\begin{matrix}1 & 1 & 0 \\ 0 & 1 & 0 \\ 0 & 1 & 1\end{matrix}\right]$ . The resulting intermediary matrices *H_{S}*⁽²⁾, *H_{T}*⁽²⁾, and *C*⁽²⁾ are determined by *L*₂*H_{S}*⁽¹⁾, *L*₂*H_{T}*⁽¹⁾, and *L*₂*C*⁽¹⁾, respectively.

In a third transformation, the third column of *H_{S}*⁽²⁾, namely $\left[\begin{matrix}1 \\ 1 \\ 1\end{matrix}\right]$, is to be converted to the third column of the identity matrix form, namely $\left[\begin{matrix}0 \\ 0 \\ 1\end{matrix}\right]$. The transformation of applying the third row to each of the first and second row is ${L}_{3} = \left[\begin{matrix}1 & 0 & 1 \\ 0 & 1 & 1 \\ 0 & 0 & 1\end{matrix}\right]$. The resulting *C*⁽³⁾, namely $\left[\begin{matrix}1 & 0 & 1 \\ 0 & 0 & 1 \\ 1 & 1 & 1\end{matrix}\right]$ is also the inverse matrix *H_{S}⁻¹.* To verify, it is shown that the product of the starting *H_{S}* and *H_{S}*⁻¹ as determined above is the identity matrix.

In accordance with one embodiment of the present disclosure, a Gaussian elimination method is provided wherein the intermediate matrices *H_{S}*⁽ⁱ⁾ are not determined in their entirety. Instead, by multiplying the matrix *C* with a single column of *H_{S},* a transformation vector of size *m* is determined that can be used to inform the linear transformations *L* which need only be performed on the matrix *C.* As such, the matrix manipulation steps involved in determining the intermediary matrices *H_{S}*^{(*i*)} are obviated, resulting in computational savings. For any *l* > 0, where *l* is the step number, the *l*-th column of *H_{S}*^{(*l*-1)} can be determined. The product of *C*^{(*l*)} with the *l*-th column of *H_{S}* can then be determined by taking the dot product of the rows of *C*^{(*l*)} with the vector of the *l*-th column of *H_{S}.*

Operations of the improved Gaussian elimination method in accordance with the present disclosure are shown in FIG. 3B using the same example as that of FIG. 3A. The first transformation *L*₁ is derived from the dot product of *C*⁽⁰⁾, or *I* in the first step, and the first column of *H_{S},* namely $\left[\begin{matrix}1 \\ 1 \\ 0\end{matrix}\right]$, as highlighted by the dotted line. The dot product yields the transformation vector $\left[\begin{matrix}1 \\ 1 \\ 0\end{matrix}\right]$, which informs the transformations to be performed to arrive at *C*⁽¹⁾. Recall that the transformations aim to convert *H_{S}* into an identity matrix. Thus, the first column of *H_{S}* is to be converted to $\left[\begin{matrix}1 \\ 0 \\ 0\end{matrix}\right]$. To this end, the first row of the matrix *H_{S}* is to be applied to any other row of the matrix that has a non-zero element in the first column. Such transformation is represented in the transformation vector. As the second element of the transformation vector is a non-zero element, the first row is to be applied to the second row. The linear transformation of applying the first row to the second row need only be performed on the *C* matrix, and any calculations previously associated with manipulation of *H_{S}* to derive *H_{S}*⁽¹⁾ are obviated. This results in savings in the number of computations to be performed. In comparison to the 18 bit-flip operations required in step 1 of the standard Gaussian elimination method, only 5 such bit-flip operations, including 3 for multiplication and 2 for row addition, are needed.

In step 2, the product of *C*⁽¹⁾ and the second column of *H_{S}* yields the second transformation vector $\left[\begin{matrix}1 \\ 1 \\ 1\end{matrix}\right]$. As the second column is being considered (i.e., *l*=2), any non-zero element other than the 2^{nd} element of the transformation vector indicates an application of the second row to that particular row. In this case, the 2^{nd} row is to be applied to both the 1^{st} and the 3^{rd} rows. Again, the transformation only needs to be performed on the intermediary matrix *C*⁽¹⁾ to yield *C*⁽²⁾.

In step 3, the transformation vector $\left[\begin{matrix}1 \\ 1 \\ 1\end{matrix}\right]$ is the product of *C*⁽²⁾ and the third column of *H_{S},* namely $\left[\begin{matrix}0 \\ 1 \\ 0\end{matrix}\right]$. Since it is the third column (i.e., *l*=3), the transformation vector indicates that the third row of *C*⁽²⁾ is to be applied to both of the first and second row of *C*⁽²⁾, respectively, resulting in *C*⁽³⁾, which is also the inverse matrix *H_{S}⁻¹.* As can be discerned, the *H_{S}⁻¹* in FIG. 3B is identical to that of FIG. 3A.

One embodiment of the present disclosure can be described as a result of a recursive relationship based on *C*^{(*i*-1)} and *A,* where *C*⁽⁰⁾ *= I* and *C*^{(*i*-1)} is the transformed matrix from the (*i* - 1)^{th} iteration. In the *i*^{th} iteration, we obtain *C*^{(*i*)} *= LᵢC*^{(*i*-1)}, where ${L}_{i} = I + {v}^{\left(i\right)} {e}_{i}^{T} - {e}_{i} {e}_{i}^{T}$ *, v*^{(*i*)} = *C*^{(*i*-1)}*A*_{:}*_{,i}, A*_{:*,i*} is the *i*^{th} column of *A,* and *eᵢ* is a column vector with *i*^{*t*h} element being 1 and the rest being 0. We note that the matrix *Lᵢ* is an elementary row transformation matrix when *v*^{(*i*)} is a vector of integers. Thus, the Gaussian elimination technique involves performing only row transformations on *C*^{(*i*-1)}s recursively.

In one exemplary embodiment, the improved Gaussian elimination method may be algorithmically implemented in accordance with the following pseudocode:
1) Let *lin_ind_col_indices* and *row*_*order* be lists that store the indices of the linearly independent columns of *A* considered and the row order at the end of the Gaussian elimination procedure, respectively. Initialise *lin_ind_col_indices* and *row*_*order* to an empty list and a vector with elements from 1 to *n,* respectively.
2) Let *n* vectors correspond to the columns of matrix *A,* with each vector containing a set of sorted indices of the non-zero elements in a particular column of *A.* Similarly, a list of *nᵣ* vectors for matrix *C* is constructed and initialised to *I*, where *nᵣ* is the number of rows of *A.* These *nᵣ* vectors correspond to the rows of matrix *C.* The matrix *C* will transform to the matrix (*A*⁻¹)*^{T}* at the end of the Gaussian elimination procedure.
3) An iterative procedure is performed where each iteration involves performing linear transformations including row permutations and row additions based on a particular row, say row *i,* of *A* as follows:
   a. the index of the first non-zero element in the *j*^{th} vector of a matrix A from a previous iteration is obtained where the index is at least *i.* Let this index be *row_index.* The *i*^{th} element of the *j*^{th} vector of transformed *A* is obtained by taking the dot product of the *row_order*[*i*]*^{th}* vector of *C* with *j*^{th} vector of *A.* If there is no non-zero element in the *j*^{th} vector of transformed *A* with index at least *i,* then *j* is incremented by 1 and this step is repeated.
   b. If *i ≠ row_index,* the elements in the *i*^{th} and *row_index^{th}* position in the list *row_order* are exchanged.
   c. Iterate *l from* 1 to *i -* 1 and from *row_index +* 1 to *nᵣ* and perform the following steps:
      i. Using the binary dot product of vectors determined in step 3(a) above, check if the *l*^{th} element of the *j*^{th} column of the transformed *A* is 1 or 0. If it is a 1, add the *row_order[i]^{th}* vector of *C* to *row_order*[*l*]*^{th}* vector of *C* using the procedure to add sparse vectors when the list of indices of non-zero elements of a sparse vector is known.
   d. Append the list *lin_ind_col_indices* with *j* and increment *i* and *j.*
4) From matrix *C*, construct the sparse matrix for *A*⁻¹ which is obtained by taking the transpose of the sparse matrix constructed from the horizontal concatenation of vectors in *C.*

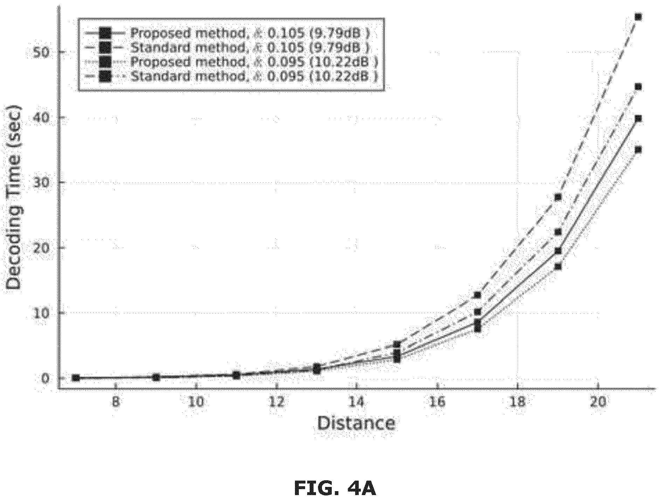

FIG. 4A illustrates the improvement in computational time (in seconds) between the BP-OSD decoding method employing the standard OSD approach and the improved OSD method described herein as a function of code distance for two squeezing factors. As may be discerned from the graph, the savings in computational time increase with longer code distances. As the code distance increases, more qubits are used to represent each code word. This results in BP taking longer to process such stabilizer data and they may lead to more trapping sets that trigger execution of the OSD. The improvement in OSD as described herein results in increased savings in computational time as shown in the graph. A higher squeezing factor is indicative of a better-defined GKP state and hence is less error prone. As shown, the improvement in computational time increases as the code length increases even with higher levels of squeezing.

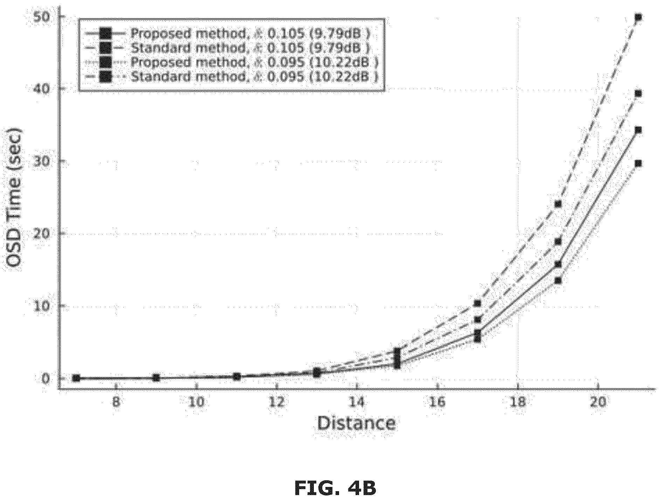

FIG. 4B illustrates the OSD portion of the computational time shown in FIG. 4A. As may be discerned from FIG. 4B in comparison with FIG. 4A, with a higher squeezing factor, most of the computational time is incurred by OSD. Being less error prone, any syndrome may be quickly processed by the BP decoder, and the runtime bottle neck rests with the OSD. With longer code length, the BP decoder takes up more execution time, but a majority of the execution time is still incurred by the OSD portion of the decoding algorithm. The improvement in the OSD computation time shown in FIG. 4B reflects the overall time savings shown in FIG. 4A.

Recall in some embodiments, an error estimation based on the Oth-order OSD may be sufficient. In such embodiments, the error vector *ê*, or the error recovery operator, may be estimated from the inverse matrix *H_{S}⁻¹* and the syndrome data *s^{T}* in accordance with Equation (18).

In some further embodiments, higher-order OSD may be needed for a more precise error recovery operator. Recall in Equation (19), higher-order OSD requires a corrective adjustment be applied based on the corrective error term *ê_{T}* in the form of *H_{S}*⁻¹*H_{T}ê_{T}^{T}.* Also recall that the order of the OSD, *k,* is defined based on the number of non-zero elements (i.e., number of binary 1's) in the term *ê_{T},* which comprises the rightmost (*n* - *r*) bits of the *n*-bit vector *ê*. In some embodiments, a combination sweep method is used in determining *ê_{T}* corresponding to the most probable error estimate.

In some embodiments, an exhaustive combination sweep method may be performed. Recall the OSD order *k* is defined based on the number of non-zero elements in *ê_{T}.* For exhaustive combination sweep, all possible permutations of (*n* - *r*) binary bits having *k* non-zero bits, each permutation forming a binary vector, are iterated through to have their respective error probabilities compared. For every resulting *ê* = [*ê_{S} ê_{T}* ], each non-zero element within the vector is representative of a qubit. Hence, the error probability associated with the particular error vector may be determined by summing up the error probabilities of each qubit indicated by a non-zero element in the vector. The *ê_{T}* that results in an *ê* with the highest error probability (i.e., represents the most likely error) is selected. In some embodiments, the error probability weight is used to select the most likely error estimate, which corresponds to *ê_{T}* that has the least error probability weight.

However, as it may be appreciated, the improved error recovery operator accuracy as determined by the exhaustive combination sweep approach may incur more computational resource and time costs. Thus, in some further embodiments, a truncated approach may be adopted for improved computational resource and time savings. In such embodiments, an optional higher-order OSD parameter *λ* is received by the OSD decoder, where *λ* specifies the first *λ* number of bits within the (*n* - *r*) bits of the *ê_{T}* vector. The user may further specify the number of non-zero elements *k* to be iterated within the *λ* bits. Thus, instead of iterating over a vector of (*n* - *r*) bits having *l* non-zero elements, the truncated combination sweep approach allows the OSD decoder to iterate over a vector of *λ* bits having *k* non-zero elements. This method permits decreased computational resources and time while still maintaining an acceptable error threshold.

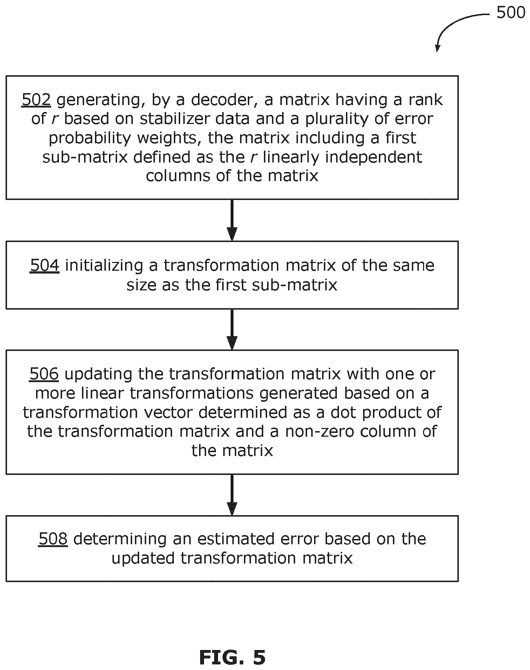

FIG. 5 shows a flowchart of a method 500 in accordance with embodiments of the present disclosure.

At 502, a decoder is configured to generate a matrix having a rank of *r* based on stabilizer data and a plurality of error probability weights. The stabilizer data may be a parity check matrix or a Tanner graph of the parity check matrix. The matrix is configured to include a first sub-matrix defined as the *r* linearly independent columns of the matrix. In some embodiments, the matrix is an *m* × *n* sparse matrix, where *n* > *m,* and the first sub-matrix is a full rank matrix of rank *r,* where *r* = *m,* and *m* is the number of rows of the first sub-matrix. In some embodiments, the decoder may also be configured to receive syndrome data in the form of a list or vector of syndromes. When using BP-OSD, this syndrome data may invoke a trapping set for a BP decoding algorithm. In further embodiments, the syndrome data may be passed directly to an OSD without prior BP processing. In some embodiments, the decoder may be configured to receive an optional parameter, *λ*, for higher order OSD analysis.

At 504, a transformation matrix is initialized as having the same size as the first sub-matrix. In some embodiments, the transformation matrix is an identity matrix.

At 506, the transformation matrix is updated with one or more linear transformations. Each linear transformation of the one or more linear transformations is generated based on a transformation vector determined as a dot product of the transformation matrix and a non-zero column of the matrix (i.e., a column that contains at least one non-zero element). In some embodiments, the updating includes iterating through at most *n* leftmost linearly independent columns of the matrix. In each iteration, a column number *i* is identified as the non-zero column of the matrix. One or more row indices for each of the non-zero elements of the transformation vector other than the *i*^{th} element of the transformation vector are identified. Then, the *i*^{th} row of the transformation matrix is applied, such as by addition or subtraction or any other suitable matrix operations, to each row of the transformation matrix identified by a row index of the one or more row indices.

At 508, an estimated error is determined based on the updated transformation matrix. The estimated error may be used to recover the original data.

Although the present disclosure may describe methods and processes with steps in a certain order, one or more steps of the methods and processes may be omitted or altered as appropriate. One or more steps may take place in an order other than that in which they are described, as appropriate.

Although the present disclosure may be described, at least in part, in terms of methods, a person of ordinary skill in the art will understand that the present disclosure is also directed to the various components for performing at least some of the aspects and features of the described methods, be it by way of hardware components, software or any combination of the two.

## Claims

1. A method of correcting syndrome data from a quantum computer, the method comprising:
receiving, at a decoder, stabilizer data, the syndrome data determined at least in part based on the stabilizer data, and a plurality of error probability weights, the decoder including one or more electronic circuits;
generating, by the decoder, a matrix having a rank of *r* based on the stabilizer data and the plurality of error probability weights, the matrix including a first sub-matrix defined as the r linearly independent columns of the matrix;
initializing, by the decoder, a transformation matrix of the same size as the first sub-matrix;
determining, by the decoder, a transformation vector as a dot product of the transformation matrix and a non-zero column of the matrix;
generating, by the decoder, one or more linear transformations of matrix row permutations and matrix row additions based on the determined transformation vector;
updating, by the decoder, the transformation matrix by applying the one or more generated linear transformations;
determining, by the decoder, an estimated error based on the updated transformation matrix; and
correcting the syndrome data based on the estimated error.

2. The method of claim 1, wherein the matrix is an *m* _{×} *n* sparse matrix, and the first sub-matrix is a full-rank matrix of rank *r,* where *r* = *m*, and is the number of rows of the first sub-matrix.

3. The method of claim 1, wherein updating, by the decoder, the transformation matrix further comprises:
iterating through at least *r* leftmost linearly independent columns of the matrix, wherein each iteration performs:
identifying, in the matrix, a column number *j* as the column with at least one non-zero element with a row index of at least *i,* and
identifying one or more row indices for each of the non-zero elements of the transformation vector other than the *i*-th element of the transformation vector; and
applying the *i*-th row of the transformation matrix to each row of the transformation matrix identified by a row index of the one or more row indices.

4. The method of claim 1 further comprising: reordering, by the decoder, the columns of the matrix based on a corresponding error probability weight from the plurality of error probability weights.

5. The method of claim 4, wherein the columns of the matrix are reordered from least to greatest error probability weight.

6. The method of claim 1, wherein each error probability weight of the plurality of error probability weights is determined by ${w}_{e} = log log \frac{1 - p}{p}$, where *p* is a probability of error.

7. The method of claim 1, wherein the matrix further includes a second sub-matrix defined as the remaining *n* - *r* columns of the matrix, where *n* is the total number of columns of the matrix, the method further comprising:
receiving, by the decoder, an ordered statistics decoding (OSD) order parameter;
iterating, by the decoder, through a plurality of binary vectors, where each binary vector of the plurality of binary vectors comprises (*n* - *r*) bits where the number of non-zero bits in each binary vector is defined by the OSD order parameter, wherein each iteration comprises:
determining a corrective error based on the second sub-matrix, the updated transformation matrix, and a respective binary vector of the plurality of binary vectors,
updating the estimated error with the corrective error to derive an updated estimated error, and
determining a probability of the updated estimated error; and
identifying a binary vector of the plurality of binary vectors that resulted in the updated estimated error having the highest error probability.

8. The method of claim 7, wherein the plurality of binary vectors includes all permutations of (*n* - *r*) bits having a number of non-zero bits specified by the OSD order parameter, and the binary vector having the highest error probability is identified as a binary vector having the lowest error probability weight.

9. The method of claim 1, wherein the estimated error represents one of a bit-flip error and a phase-flip error.

10. The method of claim 7, wherein the updated estimated error *ê_{S}* is determined by *ê_{S}^{T}* = *ê_{S}*⁽⁰⁾*^{T} - H_{S}*⁻¹*H_{T}ê_{T}^{T},* where *ê_{S}*⁽⁰⁾ is the estimated error, *ê_{T}* is the corrective error, *H_{S}*⁻¹ is the updated transformation matrix, *H_{T}* is the second sub-matrix, and *ê_{T}^{T}* is a binary vector of the plurality of binary vectors.

11. The method of claim 10, wherein the updated estimated error *ê_{S}* is a binary string of *n* bits, where the first *r* bits correspond to the estimated error, and the remaining (*n* - *r*) bits correspond to the corrective error.

12. The method of claim 10, wherein the estimated error *ê_{S}*⁽⁰⁾ is determined by *ê_{S}*^{(0)*^{T}*} = *H_{S}*⁻¹*s^{T},* where *s^{T}* is the syndrome data.

13. The method of claim 1, wherein the plurality of error probability weights is a plurality of updated error probability weights generated by an alternate decoding method.

14. The method of claim 13, wherein the alternate decoding method is a belief propagation method.

15. The method of claim 1, wherein the stabilizer data is one of a check matrix or a Tanner graph.

## Patentansprüche

1. Verfahren zum Korrigieren von Syndromdaten von einem Quantencomputer, wobei das Verfahren Folgendes umfasst:
Empfangen von Stabilisatordaten an einem Decoder, wobei die Syndromdaten zumindest teilweise basierend auf den Stabilisatordaten bestimmt werden, und mehreren Fehlerwahrscheinlichkeitsgewichtungen, wobei der Decoder eine oder mehrere elektronische Schaltungen enthält;
Erzeugen einer Matrix mit einem Rang von r durch den Decoder basierend auf den Stabilisatordaten und den mehreren Fehlerwahrscheinlichkeitsgewichtungen, wobei die Matrix eine erste Untermatrix enthält, die als die r linear unabhängigen Spalten der Matrix definiert ist;
Initialisieren einer Transformationsmatrix der gleichen Größe wie die erste Untermatrix durch den Decoder;
Bestimmen eines Transformationsvektors als Punktprodukt der Transformationsmatrix und einer Spalte ungleich Null der Matrix durch den Decoder;
Erzeugen einer oder mehrerer Lineartransformationen von Matrixzeilenpermutationen und Matrixzeilenadditionen basierend auf dem bestimmten Transformationsvektor durch den Decoder;
Aktualisieren der Transformationsmatrix durch Anwenden der einen oder der mehreren erzeugten Lineartransformationen durch den Decoder;
Bestimmen eines geschätzten Fehlers basierend auf der aktualisierten Transformationsmatrix durch den Decoder und
Korrigieren der Syndromdaten basierend auf dem geschätzten Fehler.

2. Verfahren nach Anspruch 1, wobei die Matrix eine m ₓ n dünn besetzte Matrix ist und die erste Untermatrix eine vollwertige Matrix des Rangs r ist, wobei r = m ist und die Anzahl von Zeilen der ersten Untermatrix ist.

3. Verfahren nach Anspruch 1, wobei das Aktualisieren der Transformationsmatrix durch den Decoder ferner Folgendes umfasst:
Iterieren durch mindestens r am weitesten links linear unabhängige Spalten der Matrix, wobei jede Iteration Folgendes durchführt:
Identifizieren einer Spaltennummer j als die Spalte mit mindestens einem Element ungleich Null mit einem Zeilenindex von mindestens i in der Matrix und
Identifizieren eines oder mehrerer Zeilenindizes für jedes der nicht-Null-Elemente des Transformationsvektors außer dem i-ten Element des Transformationsvektors und
Anwenden der i-ten Zeile der Transformationsmatrix auf jede Zeile der Transformationsmatrix, die durch einen Zeilenindex des einen oder der mehreren Zeilenindizes identifiziert wird.

4. Verfahren nach Anspruch 1, das ferner Folgendes umfasst: Neuordnen der Spalten der Matrix durch den Decoder basierend auf einer entsprechenden Fehlerwahrscheinlichkeitsgewichtung aus den mehreren Fehlerwahrscheinlichkeitsgewichtungen.

5. Verfahren nach Anspruch 4, wobei die Spalten der Matrix von der geringsten zur größten Fehlerwahrscheinlichkeitsgewichtung umgeordnet werden.

6. Verfahren nach Anspruch 1, wobei jede Fehlerwahrscheinlichkeitsgewichtung der mehreren Fehlerwahrscheinlichkeitsgewichtungen durch ${w}_{e} = log log \frac{1 - p}{p}$ bestimmt wird, wobei p eine Fehlerwahrscheinlichkeit ist.

7. Verfahren nach Anspruch 1, wobei die Matrix ferner eine zweite Untermatrix beinhaltet, die als die verbleibenden n - r Spalten der Matrix definiert ist, wobei n die Gesamtanzahl von Spalten der Matrix ist, wobei das Verfahren ferner Folgendes umfasst:
Empfangen eines Ordnungsparameters zum Decodieren geordneter Statistiken (OSD) durch den Decoder;
Iterieren durch mehrere binäre Vektoren durch den Decoder, wobei jeder binäre Vektor der mehreren binären Vektoren (n - r) Bits umfasst, wobei die Anzahl von Bits ungleich null in jedem binären Vektor durch den OSD-Ordnungsparameter definiert ist, wobei jede Iteration Folgendes umfasst:
Bestimmen eines Korrekturfehlers basierend auf der zweiten Untermatrix, der aktualisierten Transformationsmatrix und einem jeweiligen Binärvektor der mehreren Binärvektoren,
Aktualisieren des geschätzten Fehlers mit dem Korrekturfehler, um einen aktualisierten geschätzten Fehler abzuleiten, und
Bestimmen einer Wahrscheinlichkeit des aktualisierten geschätzten Fehlers und
Identifizieren eines binären Vektors der mehreren binären Vektoren, die zu dem aktualisierten geschätzten Fehler mit der höchsten Fehlerwahrscheinlichkeit führten.

8. Verfahren nach Anspruch 7, wobei die mehreren binären Vektoren alle Permutationen von (n - r) Bits mit einer Anzahl von Bits ungleich null beinhalten, die durch den OSD-Ordnungsparameter spezifiziert werden, und der binäre Vektor mit der höchsten Fehlerwahrscheinlichkeit als binärer Vektor mit der niedrigsten Fehlerwahrscheinlichkeitsgewichtung identifiziert wird.

9. Verfahren nach Anspruch 1, wobei der geschätzte Fehler einen Bit-Flip-Fehler oder einen Phasen-Flip-Fehler repräsentiert.

10. Verfahren nach Anspruch 7, wobei der aktualisierte geschätzte Fehler ê_{S} durch ê_{S}^{T} = *ê_{S}*^{(0)*^{T}*} - Hₛ⁻¹H_{T}ê_{T}^{T} bestimmt wird, wobei ê_{S}⁽⁰⁾ der geschätzte Fehler ist, ê_{T} der korrigierende Fehler ist, H_{S}⁻¹ die aktualisierte Transformationsmatrix ist, H_{T} die zweite Untermatrix ist und ê_{T}^{T} ein binärer Vektor der mehreren binären Vektoren ist.

11. Verfahren nach Anspruch 10, wobei der aktualisierte geschätzte Fehler ê_{S} eine binäre Kette von n Bits ist, wobei die ersten r Bits dem geschätzten Fehler entsprechen und die verbleibenden (n - r) Bits dem Korrekturfehler entsprechen.

12. Verfahren nach Anspruch 10, wobei der geschätzte Fehler *ê_{S}*⁽⁰⁾ durch *ê_{S}*^{(0)*^{T}*} = H_{S}⁻¹s^{T} bestimmt wird, wobei s^{T} die Syndromdaten sind.

13. Verfahren nach Anspruch 1, wobei die mehreren Fehlerwahrscheinlichkeitsgewichtungen mehrere aktualisierte Fehlerwahrscheinlichkeitsgewichtungen sind, die durch ein alternatives Decodierungsverfahren erzeugt werden.

14. Verfahren nach Anspruch 13, wobei das alternative Decodierungsverfahren ein Belief-Propagation-Verfahren ist.

15. Verfahren nach Anspruch 1, wobei die Stabilisatordaten eine Prüfmatrix oder ein Tanner-Graph sind.

## Revendications

1. Procédé de correction de données syndromiques provenant d'un ordinateur quantique, le procédé comprenant les faits suivants :
recevoir, au niveau d'un décodeur, des données stabilisatrices, les données syndromiques étant déterminées au moins en partie sur la base des données stabilisatrices, et une pluralité de poids de probabilité d'erreur, le décodeur incluant un ou plusieurs circuits électroniques ;
générer, par le décodeur, une matrice ayant un rang de r sur la base des données stabilisatrices et de la pluralité de poids de probabilité d'erreur, la matrice incluant une première sous-matrice définies comme étant les r colonnes linéairement indépendantes de la matrice ;
initialiser, par le décodeur, une matrice de transformation de la même taille que la première sous-matrice ;
déterminer, par le décodeur, un vecteur de transformation sous forme de produit scalaire de la matrice de transformation et une colonne non zéro de la matrice ;
générer, par le décodeur, une ou plusieurs transformations linéaires de permutations de rangée de matrice et d'additions de rangée de matrice sur la base du vecteur de transformation déterminé ;
mettre à jour, par le décodeur, la matrice de transformation en appliquant l'une ou les plusieurs transformations linéaires générées ;
déterminer, par le décodeur, une erreur estimée, sur la base de la matrice de transformation mise à jour ; et
corriger les données syndromiques sur la base de l'erreur estimée.

2. Procédé de la revendication 1, dans lequel la matrice est une matrice creuse m × n, et la première sous-matrice est une matrice de plein rang de rang r, où r = m, et est le nombre de rangées de la première sous-matrice.

3. Procédé de la revendication 1, dans lequel le fait de mettre à jour, par le décodeur, la matrice de transformation comprend en outre les faits suivants :
itérer à travers au moins r colonnes linéairement indépendantes les plus à gauche de la matrice, dans lequel chaque itération réalise les faits :
d'identifier, dans la matrice, un numéro de colonne j comme étant la colonne avec au moins un élément non zéro avec un indice de rangée d'au moins i, et
d'identifier un ou plusieurs indices de rangée pour chacun des éléments non zéro du vecteur de transformation autre que le i-ième élément du vecteur de transformation ; et
appliquer la i-ième rangée de la matrice de transformation à chaque rangée de la matrice de transformation identifiée par un indice de rangée de l'un ou des plusieurs indices de rangée.

4. Procédé de la revendication 1 comprenant en outre : le fait de réordonner, par le décodeur, les colonnes de la matrice sur la base d'un poids de probabilité d'erreur correspondant parmi la pluralité de poids de probabilité d'erreur.

5. Procédé de la revendication 4, dans lequel les colonnes de la matrice sont réordonnées du poids de probabilité d'erreur le plus petit au plus grand.

6. Procédé de la revendication 1, dans lequel chaque poids de probabilité d'erreur de la pluralité de poids de probabilité d'erreur est déterminé par ${w}_{e} = log log \frac{1 - p}{p}$ *,* où p est une probabilité d'erreur.

7. Procédé de la revendication 1, dans lequel la matrice inclut en outre une seconde sous-matrice définies comme étant les n - r colonnes restantes de la matrice, où n est le nombre total de colonnes de la matrice, le procédé comprenant en outre les faits suivants :
recevoir, par le décodeur, un paramètre d'ordre de décodage statistique ordonné (Ordered Statistics Decoding, OSD) ;
itérer, par le décodeur, à travers une pluralité de vecteurs binaires, où chaque vecteur binaire de la pluralité de vecteurs binaires comprend (n - r) bits où le nombre de bits non zéro dans chaque vecteur binaire est défini par le paramètre d'ordre OSD, dans lequel chaque itération comprend les faits :
de déterminer une erreur corrective sur la base de la seconde sous-matrice, de la matrice de transformation mise à jour, et d'un vecteur binaire respectif de la pluralité de vecteurs binaires,
de mettre à jour l'erreur estimée avec l'erreur corrective pour dériver une erreur estimée mise à jour, et
de déterminer une probabilité de l'erreur estimée mise à jour ; et
identifier un vecteur binaire de la pluralité de vecteurs binaires qui a eu pour résultat l'erreur estimée mise à jour ayant la probabilité d'erreur la plus élevée.

8. Procédé de la revendication 7, dans lequel la pluralité de vecteurs binaires inclut toutes les permutations de (n - r) bits ayant un nombre de bits non zéro spécifié par le paramètre d'ordre OSD, et le vecteur binaire ayant la probabilité d'erreur la plus élevée est identifié comme étant un vecteur binaire ayant le poids de probabilité d'erreur le plus bas.

9. Procédé de la revendication 1, dans lequel l'erreur estimée représente une erreur parmi une erreur de basculement de bit et une erreur de basculement de phase.

10. Procédé de la revendication 7, dans lequel l'erreur estimée mise à jour ê_{S} est déterminée par ê_{S}^{T} = *ê_{S}*^{(0)*^{T}*} - Hₛ⁻¹H_{T}ê_{T}^{T}, où ê_{S}⁽⁰⁾ est l'erreur estimée, ê_{T} est l'erreur corrective, H_{S}⁻¹ est la matrice de transformation mise à jour, H_{T} est la seconde sous-matrice, et ê_{T}^{T} est un vecteur binaire de la pluralité de vecteurs binaires.

11. Procédé de la revendication 10, dans lequel l'erreur estimée mise à jour êₛ est une chaîne binaire de n bits, où les r premiers bits correspondent à l'erreur estimée, et les (n - r) bits restants correspondent à l'erreur corrective.

12. Procédé de la revendication 10, dans lequel l'erreur estimée *ê_{S}*⁽⁰⁾ est déterminée par *ê_{S}*^{(0)*^{T}*} = H_{S}⁻¹s^{T}, où s^{T} sont les données syndromiques.

13. Procédé de la revendication 1, dans lequel la pluralité de poids de probabilité d'erreur est une pluralité de poids de probabilité d'erreur mis à jour générés par une variante de procédé de décodage.

14. Procédé de la revendication 13, dans lequel la variante de procédé de décodage est un procédé de propagation de croyance.

15. Procédé de la revendication 1, dans lequel les données stabilisatrices sont un élément parmi une matrice de contrôle ou un graphe de Tanner.
